# EUROPEAN PATENT APPLICATION

(11) **EP 1 312 638 A1**
(43) Date of publication of application: **21.05.2003**
(21) Application number: 01204400.4
(22) Date of filing: 16.11.2001
(51) Int. Cl.: C08K 5/5357, C08K 5/5313, C08K 5/00, C08L 63/00, C08J 5/24, B32B 27/38

(54) **Halogen-free phosphorous-and nitrogen-containing flame-resistant epoxy resin compositions, and prepregs derived from thereof**

(71) Applicant: Resolution Research Nederland B.V., 1031 CM Amsterdam (NL)
(72) Inventor: De Velder, Helga Leontine Andrea, 1348 Ottignies Louvain-la-Neuve (BE); Stevens, Philippe Eric, 1348 Ottignies Louvain-la-Neuve (BE); Heine, Francoise Marie Louise, 1348 Ottignies Louvain-la-Neuve (BE); Rivière, Jean Andre Alfred, 1348 Ottignies Louvain-la-Neuve (BE)
(74) Representative: Wittop Koning, Tom Hugo

(57) **Abstract**

Curable flame-resistant substantially halogen free epoxy resin compositions, comprising:
(a) one or more bifunctional and/or polyfunctional epoxy resin;
(b) at least two specific phosphorous-containing compounds;
(c) a curing agent consisting of oligomers triazine modified cresol novolac comprising at least cresol condensate wherein a cresol compound (X) and a triazine compound (Y) have been condensed via aldehydes (Z),
optionally (d) a curing catalyst and optionally (e) additives;
prepregs derived from said compositions and laminates derived from said prepregs.

## Description

The invention relates to substantially halogen-free phosphorous- and nitrogen-containing flame-retardant epoxy resin compositions, to prepregs derived by impregnation of porous webs, and to composites and in particular to laminates, derived from said prepregs and to be used in printed circuit boards.

Composites based on epoxy resins and inorganic or organic reinforcing materials have become very important in many industrial fields and in everyday life. The reasons therefore are, on the one hand, the relatively simple and safe processing of epoxy resins and, on the other hand, the good mechanical and chemical properties of cured epoxy resin moulded materials, which allow adaptation to different applications and advantageous utilization of the properties of all the materials which are part of the composite.

Epoxy resins are advantageously processed into composites via preparation of prepregs. For this purpose inorganic or organic reinforcing materials or embedding components in the form of fibres, non-woven and woven fabrics, or of flat-shaped articles are impregnated with the resin. In most cases this is accomplished with a solution of the resin in an easy-to-evaporate or easy-to-volatilize solvent. The prepregs thus obtained after heating, must no longer be tacky, but must not yet be hardened after this process, but rather the resin matrix must be in a prepolymerized state. In addition, the prepregs must have sufficiently long shelf life. Thus, for example, a shelf life of at least three months is required for circuit board manufacturing. When they are further processed into composites, the resin in the prepregs must also melt and flow on when the temperature is increased and must bond with the reinforcing materials or embedding components as well as with the materials provided for the composite as firmly and permanently as possible under pressure, i.e. the cross-linked epoxy resin matrix must have a high interfacial adhesion to the reinforcing materials, or embedding components, as well as to the materials to be bonded such as metals, ceramics, minerals, and organic materials.

In the cured state, composites are normally expected to have high mechanical strength and thermal stability, as well as chemical resistance, and heat distortion or resistance to ageing. For electrotechnical and electronic applications, the requirements also include permanently high electrical insulation capability and, for special applications, a plurality of other requirements. For use as circuit board material, for example, high dimensional stability over a broad temperature range, good adhesion to glass and copper, high surface resistivity, low dielectric loss factor, good machinability (punchability, drillability), low water absorption, and high chemical resistance are required.

With increasing load and intensive use of the composites, in particular the requirement for heat distortion becomes especially important. This means that the materials must resist high temperatures without deformation or damage of the composite, for example by delamination, during processing and use. Circuit boards, for example, are exposed to temperatures of over 288°C during flow soldering. Temperatures over 200 °C may also occur temporarily and in a limited area during cutting and drilling. Materials with a high glass transition temperature have advantageous characteristics in this respect. If the glass transition temperature is above the aforementioned values, dimensional stability in the temperature range prevailing during processing is generally ensured and damage such as warping and delamination are mostly avoided. The epoxy resin currently used worldwide for FR4 laminates has a glass transition temperature Tg of only 130 °C after curing. This results, however, in the above-mentioned type of damage and failure during manufacturing. Therefore, it is still desired to have comparatively easy-to-process and inexpensive materials with a glass transition temperature Tg of up to approximately 180 °C, and more preferably in the range of from 140 to 180 °C.

Another requirement that is becoming more and more important is that of flame resistance. In many areas this requirement has first priority due to possible hazards to people and property, for example, in construction materials for aircraft and automobile manufacturing, as well as for vehicles in public transportation. Flame resistance of circuit board materials is essential in electro-technical, but especially electronic applications due to the high value of the electronic components mounted on the boards, and the risk of fire caused by a short circuit.

Therefore materials must pass one of the strictest tests and attain V-0 classification by UL 94, for evaluating their flammability. In this test, a test object is exposed to a well-defined flame positioned vertically under its lower edge. The sum of burning times in ten tests (5 samples, each sample of which is submitted to a standard flame twice) may not exceed 50 s. This requirement is difficult to meet, especially if the material is thin, as is the case in electronics. The epoxy resin industrially used world-wide for FR4 laminates only meets these requirements because it contains approximately 30% to 40% ring-brominated aromatic epoxy components, with reference to the resin, i.e. approximately 17%-21% bromine. For other applications, comparably high concentrations of halogen compounds are used, often also combined with antimony trioxide as a synergist. The problem with these compounds is that, while they are highly effective as fireproofing agents, they also have very objectionable properties. Thus, antimony trioxide is listed as a carcinogenic chemical, and aromatic bromine compounds, during thermal decomposition, not only split off bromine radicals and hydrogen bromide, which are highly corrosive, but, especially the highly brominated aromatic compounds may also form highly toxic polybromine benzofurans and polybromine benzodioxins upon decomposition in the presence of oxygen. The disposal of bromine-containing waste materials and toxic waste represents another problem.

Materials that partially or fully meet the heat distortion requirement include, for example, bismaleimide/triazine (BT)-based moulded materials with a Tg of approximately 200 °C or polyimide (PI) with a Tg of 260 °C to 270 °C. Recently also BT/epoxy blends with a Tg of 180 °C, as well as cyanate ester resins with a Tg > 200 °C, have also become available. Laminates manufactured with these resins systems exhibit, however, poorer processing and machining characteristics compared to epoxy resin-based laminates. Thus, for example, the production of PI-based laminates requires press temperatures of approximately 230 °C and considerably longer after-curing times (approx. 8 h) at temperatures of 230 °C. Another disadvantage of these resin systems is their six to ten times higher material costs.

A comparatively expensive resin system is obtained if aromatic and/or heterocyclic polyepoxy resins, i.e. polyglycidyl compounds, are combined with aromatic polyamines acting as hardening agents. Such polyamines known, for example, from German Patent 2,743,680, result in network polymers that exhibit a particularly high heat distortion and resistance to ageing. European Patent No. 0,274,646B discloses that, using 1,3,5-tris(3-amino-4-alkylphenyl)-2,4,6-trioxohexahydrotriazines as hardening agents, laminates with a glass transition temperature of up to 245 °C and good processing and machining characteristics can be obtained.

Although the above-mentioned resin systems have a widely different flammability, they all share the disadvantage of being insufficiently flame-retardant. Therefore, in order to meet the requirement of passing the UL 94 combustibility test via V-0 classification, which is essential for many applications, the use of highly effective bromine-containing fireproofing agents cannot be avoided. As a result, the potential hazard associated with bromine compounds must be taken into account.

For these reasons, extensive research has been conducted to replace bromine-containing fireproofing agents with less problematical substances. Thus, for example, fillers (with extinguishing gas effects such as aluminium oxide hydrates (see J. Fire and Flammability, Vol. 3 (1972), pp. 51 ff), basic aluminium carbonates (see Plast. Engng., Vol. 32 (1976), pp. 41 ff) and magnesium hydroxides (European application No. 0,243,201A), as well as vitrifying fillers such as borates (see Modern Plastics, Vol. 47(1970), No. 6, pp. 140 ff) and phosphates (US Patent No. 2,766,139 and US Patent No. 3,398,019) have been proposed. Most of these fillers have, however, the disadvantage of worsening, in some cases considerably, the mechanical, chemical, and electrical properties of the composites. In addition, they can leach out of the resin matrix during further processing of the printed circuit board and pollute therefore the processing solutions and cause non-homogeneous laminates. As said filler containing resin compositions tend to sedimentation and increase the viscosity of the filled resin system, they require more complicated processing methods.

The flame-retardant properties of red phosphorus has also been described (UK Patent No. 1,112,139), optionally in combination with finely dispersed silicon dioxide or aluminium oxide hydrate (US Patent No. 3,373,135). According to these documents, materials are obtained which use in electro-technical and electronic applications is limited due to the phosphoric acid produced in the presence of moisture and the associated corrosion. Moreover the formation of phosphines is expected when red phosphorus is contacted with moisture at higher temperatures. Organic phosphorus compounds, such as phosphoric acid esters, phosphonic acid esters and phosphines, have also been proposed as flame-retardant additives (see W.C. Kuryla and A.J. Papa Flame Retardance of Polymeric Materials, Vol. 1, Marcel Dekker Inc., New York, 1973, pp. 24-38 and 52-61). Since these compounds are known for their "softening" characteristics and are therefore extensively used world-wide as plasticizers for polymers (UK Patent No. 19,794), this alternative is therefore also not very promising in the present application field.

In order to achieve flame-resistance according to UL 94 V-0, German Offenlegungsschrift 3,836,409 discloses a method for preparing prepregs by impregnating certain reinforcing materials or flat-shaped articles with a suspension of halogen-free, nitrogen- and phosphorus-containing fireproofing agents in a solution of aromatic, heterocyclic, and/or cycloaliphatic epoxy resins (in a non-ring-halogenated form or a ring-halogenated form with low halogen content) and aromatic polyamines and/or aliphatic amines acting as hardening agents. The fireproofing agents are halogen-free melamine resins or organic phosphoric acid esters, particularly melamine cyanurates, melamine phosphates, triphenyl phosphate and diphenylcresyl phosphate, as well as their mixtures. This, however, is also not a very promising solution, since the fillers used always increase water absorption and therefore prevent the material from passing the circuit board-specific tests.

Organic phosphorus compounds, such as epoxy group-containing phosphorus compounds, which can be anchored in the epoxy resin network, can also be used for providing epoxy resins with flame-retarding characteristics. Thus, European Patent No. 0,384,940B discloses epoxy resin mixtures containing a commercially available epoxy resin, the aromatic polyamine 1,3,5-tris(3-amino-4-alkylphenyl)-2,4,6-trioxo-hexahydrotriazine and an epoxy group-containing, glycidyl phosphate-, glycidyl phosphonate- or glycidyl phosphinate-based phosphorus compound. With such epoxy resin mixtures, flame-retardant laminates or composites that meet the V-0 classification requirements of UL 94 and have a glass transition temperature > 200 °C, can be obtained without adding halogens. Furthermore, these epoxy resin mixtures can be processed in a manner similar to that used for currently used epoxy resins.

Circuit boards constitute the basis for the production of electronic assemblies. They are used for connecting a variety of electronic and micro-electronic components with one another to form electronic circuits. The components are connected to the circuit board by gluing or soldering using complex, highly automated assembly processes. Also in automatic insertion, there is a trend toward more streamlined manufacturing methods. Therefore IR reflow soldering, expected to replace other soldering processes in the future, is increasingly used in for Surface Mount Technology (SMT). In this process, the entire circuit board is heated to temperatures > 260 °C, in a few seconds using IR radiation; this instantly evaporates any water absorbed in the circuit board. Only laminates with excellent interlaminar adhesion survive IR soldering processes without being destroyed by delamination. In order to reduce this hazard, expensive conditioning processes have been proposed (see Galvanotechnik, Vol. 84 (1993), pp. 3865-3870).Trend to use lead-free solder which implies higher working temperatures and request boards with higher heat resistance.

It is known that in laminates with high glass transition temperature, for example, based on PI- or BT-resins, the interlaminar adhesion is weaker than in the halogen-containing FR4 laminates that are being predominantly used today; this is also true for the laminates known from European Patent No. 0,384,940B. Most of the circuit boards manufactured today are multilayer (ML) circuit boards, which contain a plurality of structured conductor planes spaced and insulated from one another by epoxy resin compounds. The current trend in ML technology, however, is toward an increasing number of structured conductor planes; thus, currently multilayer circuit boards with more than 20 structured conductor planes are being manufactured. Since excessive overall thickness of these circuit boards must be avoided for technical reasons, the distance between the structured conductor planes is becoming increasingly smaller and thus interlaminar adhesion and copper adhesion in ML laminates with high glass transition temperature is becoming more and more problematic. In addition, this type of circuit board must have a high solder bath resistance in the case of IR soldering.

As stated earlier, it is known from European Patent No. 0,384,940B that laminates with a flame resistance meeting the requirements can be obtained without using halogens through phosphorus modification of impregnation resins. It was found, however, durtrig production research, that phosphorus-modified laminates are subject to delamination during IR soldering. Therefore, urgent need has arisen for electro-laminates having the required flame resistance without the use of halogens, for example through incorporating phosphorus into the resin matrix, but which are also suitable for IR soldering required SMT. This requires electro-laminates with extremely high solder bath resistance. In circuit board technology, the high-pressure cooker test (HPCT) and the determination of solder bath resistance are primarily used to test the suitability of laminates for high thermal stressing. In HPCT, a laminate specimen (5x5 cm or 10x10 cm), freed of copper, is exposed to 120 °C and approximately 1 bar steam pressure for 30 minutes and then dipped for 20 seconds in a solder bath at 260 °C.

The aspect of the laminates is then evaluated according to a scale going from 1 to 5 (1 being the worse case), depending on the presence of blisters, measles or delamination. The test is described in IPC-TM-650 (test 2.6.16).

More recent efforts aiming at compositions for the manufacture of prepregs, the laminates of which can meet all the herein before depicted requirements, can be derived from e.g. WO99/00451; WO98/13407; US 5,756,638; US 5,759,690; US 5,817,736; US 5,760,146; US 5,648,171; Japanese Kokai Hei 11-124.489 and Japanese Kokai Hei 11-158.251, commonly proposing the use of resin systems, which comprise one or more expensive constituents.

It will be appreciated that there is still a need for further improved resin systems for the manufacture of prepregs and electric laminates thereof, which are halogen free and which meet the present depicted electronic industry requirements and which can be produced at acceptable costs.

Therefor an object of the present invention is to provide further improved resin systems, which can provide laminates for electric printed circuit boards, meeting the modern industry requirements according to FR-4,FR-5 and CEM-3 and which can be produced at acceptable costs.

As a result of extensive research and experimentation said compositions and prepregs and laminates aimed at have surprisingly been found.

Accordingly the invention relates to curable flame-resistant substantially halogen free epoxy resin compositions, comprising:
(a) one or more polyfunctional epoxy phenolic novolac and preferably an epoxy ortho-cresol novolac; by the term phenolic novolac is meant condensation products of phenolic compounds such as Bisphenol A, Bisphenol F, phenol, cresol, tetraphenylolethane and the like with formaldehyde;
(b) at least one phosphorous-containing compound selected from the group consisting of: 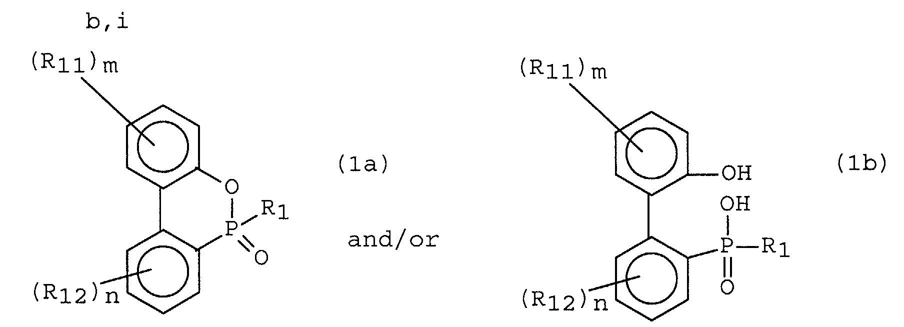 wherein R₁ represents hydrogen or an alkyl group having from 1 to 8 carbon atoms and preferably from 1 to 4 carbon atoms, wherein R₁₁ and R₁₂ are the same or different and both may represent hydrogen or alkyl having from 1 to 3 carbon atoms and wherein m and n are the same or different integers from 0 to 4.
   b,ii at least one compound selected from the group selected from 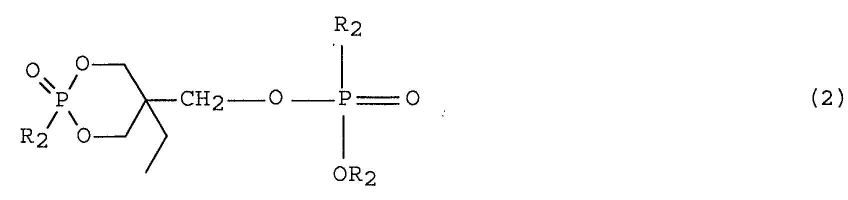 and/or 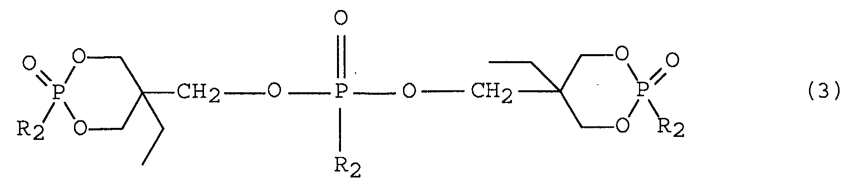 and mixtures thereof,
   wherein R₂ represents an alkyl group having from 1 to 4 carbon atoms, and preferably 1 carbon atom,
   and
(c) a triazine modified cresol novolac (as curing agent), comprising at least cresol condensate wherein a cresol compound (X) and a triazine compound (Y) have been condensed via aldehydes (Z);
optionally (d) a curing catalyst; and optionally (e) additives.

With the term "substantially halogen free" as used throughout the specification is meant that no halogen containing components (a) are included in the compositions of the present invention.

In particular no epoxy resins are included, which contain halogen substituents in the aromatic ring moieties and in particular bromine or chlorine substituents.

In the hereinbefore specified compositions the component (a) may be selected from a great variety of epoxy resins, having at least two epoxy groups per molecule.

Preferred examples of said epoxy resins are polyfunctional epoxy resins of the ortho cresol novolac type such as EPON 164 and EPIKOTE 180 epoxy resins (EPON and EPIKOTE are trademarks).

More preferably a polyfunctional epoxy resin derived from ortho cresol novolac is applied or mixtures thereof with minor amounts (<20 wt% of total weight of component (a)) of diglycidyl ethers of bisphenol A or polyfunctional epoxy resins derived from phenolic components, such as epoxy resins derived from phenol novolacs or tetraphenylolethane. Most preferred are polyfunctional epoxy resins derived from ortho cresol novolac in combination with minor amounts (<5 wt%) of polyfunctional epoxy resins, derived from phenolic components, such as epoxy resins derived from phenol novolacs or tetraphenylolethane.

As component (b) phosphorous containing compounds can be used of the formulae (1)-(3), providing a phosphorous content in the complete compositions of from 1.5 to 4.5 wt% and preferably from 1.5 to 3.5 wt%.

It will be appreciated that phosphorous containing compounds of formulae (1)-(3) are used in combinations.

As component (b) phosphorous compounds, available under the trade-names EXOLIT (Trademark) and POLYDIS (Trademark) are applied, such as EXOLIT OP910 (Clariant), POLYDIS 3710 (Schill and Seilacher).

Preferred component (1a) is that one, wherein R₁ is hydrogen and m and n are 0, i.e. dihydro-9-oxa-10-phosphaphenantrene-10-oxide. A less preferred component (1b) is the hydrolysed derivative thereof. More preferably, for most optimal product application, component b,i of formulae 1a is used, wherein R₁ is hydrogen and m and n are 0, in a mixture with phosphor compounds of formulae (2) and/or (3), and wherein all groups R₂ represent a CH₃ group.

Preferably, the triazine modified cresol resin used as component (c) is prepared by reacting an aqueous solution of formaldehyde with a triazine ring-containing compound to introduce methylol groups into the triazine ring-containing compound. A large number of triazine rings are introduced into the cresol resin by this reaction, thereby making it possible to improve the flame retardancy of an epoxy cured product.

After a cresol is added to the obtained reaction solution to carry out a dehydration reaction, or the methylol product is alkoxylated with an alcohol to carry out an alcohol removing reaction, unreacted cresol is distilled off to obtain a cresol resin.

The method of carrying out an alcohol removing reaction after the methylol product is alkoxylated with an alcohol is preferred because the homopolymerization of the triazine compound can be prevented.

Examples of the triazine ring-containing compound include melamine, acetoguanamine, ethylguanamine, butylguanamine, benzoguanamine, vinylguanamine, preferably melamine is used.

As for the reaction method, a methylol product is formed by using 1 to 10 moles of formaldehyde based on 1 mole of the triazine ring-containing compound at a temperature of 30 to 150°C. The dehydration or alcohol removing reaction is carried out at a temperature of 50 to 200°C by using the cresol and preferably ortho-cresol in an amount of 2 to 30 moles based on 1 mole of the obtained methylol product to obtain a cresol resin.

The blending ratio of the polyfunctional epoxy phenolic novolac resin as the component (a) to the triazine modified cresol novolac resin as the component (c) is such that the amount of the hydroxyl group of the cresol resin as the component (c) becomes 0.1 to 2 equivalents, preferably 0.2 to 1.5 equivalents based on 1 equivalent of the epoxy group of the epoxy resin as the component (a).

Outside the above range, the heat resistance and the humidity resistance of the epoxy resin cubing agent are imbalanced disadvantageously, and therefore not preferable.

As component (d) a curing catalyst can optionally be added in the thermosetting resin composition of the present invention for the purpose of promoting curing. Preferred examples of the curing accelerator include the following.

### (1) tertiary amines;

tri-n-butylamine, benzyldimethylamine, 2,4,6-tris(dimethylaminomethyl)phenol, 1,8-diazabicyclo(5,4,0)undecene-7, 1,5-diazabicyclo(4,3,0)nonene-7 and the like, and salts thereof.

### (2) imidazoles;

2-methylimidazole, 2-ethyl-4-methylimidazole, 1-benzyl-2-methylimidazole, 2-undecylimidazole, 2-phenylimidazole and the like, and salts thereof.

### (3) organic phosphines;

tributylphosphine, tricyclohexylphosphine, triphenylphosphine and tris(dimethoxyphenyl)phosphine, and salts thereof.

A preferred curing catalyst is 2-methyl imidazole (2MI) or 2-phenylimidaze (2-PI). These curing accelerators may be used alone or in combination of two or more. The amount of the curing accelerator is 0.0 to 5 parts by weight, preferably 0.0 to 1 parts by weight based on 100 parts by weight of the total solid content of all components.
when the amount is larger than 1 parts by weight, the processability is becoming more difficult.

Optional components (e) may be added to the thermosetting resin composition of the present invention as required.
(ei) The flame retardancy can optionally be further improved by adding a metal hydroxide or metal oxide in the thermosetting composition of the present invention, such as Al(OH)₃, Mg(OH)₂, Zn(OH)₂, Al₂O₃, MgO and the like.
(eii) Powdery reinforcement and filler; for example, metal oxides such as aluminum oxide and magnesium oxide.

They are used in an amount upto 300 parts by weight based on 100 parts by weight of the sum of the epoxy resin and the curing agent.
(eiii) Curable monomers, oligomers and synthetic resins can be added for the purpose of improving the properties of a resin in the final coating film, adhesive layer, molded product and the like. For example, combination of one or more of an epoxy resin diluent such as monofunctional glycidyl ethers (e.g. Eponol 53, Eponol 55,HELOXY 62, HELOXY is a trade-mark), a phenolic resin other than component (c) of the present invention, alkyd resin, melamine resin, fluororesin, vinyl chloride resin, acrylic resin, silicone resin and polyester resin may be used. The proportion of the resin(s) is such that it does not impair the original properties of the resin composition of the present invention, that is, preferably 10 parts or less by weight based on 100 parts by weight of the total of the epoxy resin and the curing agent.

Means of blending the epoxy resin of the present invention, an epoxy resin curing agent and optional components may be thermal melt mixing, melt kneading with a roll or kneader, wet mixing with an appropriate organic solvent, dry mixing, or the like. The more preferred is the wet mixing with an appropriate organic solvent.

More preferred complete compositions of the invention ready for the manufacture of prepregs are those comprising:
(a) a polyfunctional epoxy resin of the ortho-cresol novolac type, such as EPON 164 epoxy resin;
(b) a phosphorous containing compound of formula (1a) and/or (1b) such as POLYDIS 3710 and a phosphorous-containing compound of formulae (2) and (3), wherein R₂ = CH₃ (e.g. EXOLIT OP 910);
(c) a triazine modified cresol resin obtained from 1 to 5 moles of an aqueous solution of formaldehyde, 1 mol of melamine, 3-10 moles of methanol and 3-10 moles of ortho-cresol, and prepared according to the procedure as described herein before.Suitable starting cresol resin can be prepared according to the process disclosed in e.g. JP 2001 226464.
(d) 2-methylimidazole as curing catalyst.

Said preferred compositions have been used for the impregnation of porous webs of glass, or aramide fibres and most preferably glass cloth, which has optionally been pretreated.

It will be appreciated that the complete compositions of the invention ready for the manufacture of prepregs (varnish) have appeared to provide a very attractive combination of properties, i.e. a combination of substantially halogen-free ingredients, a well-controlled reactivity of the varnish, a high Tg of the cured varnish between 150°C to 180°C, excellent heat resistance (TGA), low water absorption and relatively low dielectric constant while the UL 94 V-0 could be reached with relatively low phosphorous content in the total composition (from 1.5 to 3.5 wt%).

Preferably the mutual weight ratios of the components (a), (b), (c), (d), and (e) are in the range of from 50-80 wt%; 5-20 wt%; 15-30 wt%; 0- 5 wt%; 0-40 wt%; and more preferably from 55-75 wt%; 10-18 wt%; 15-25 wt%; 0.0- 1 wt%; 0-10 wt%, the sum of the component amounts being 100%.

It will be appreciated by a person skilled in the art that the ingredients (a), (b), (c) are preferably used in the form of a premix in a suitable polar solvent, such as alcohols, esters or ketones and preferably methyl ethyl ketone or methyl proxitol.

Optionally component (d) and optionally (e) can be added as such or as a solution in the same or similar solvent.

Another aspect of the present invention is formed by the prepregs and laminates derived from the complete varnish compositions and chopped glass fibres, glass matt, or porous, non-woven or woven webs of glass fibre, aramide fibre (e.g. TWARON) (TWARON is a trade mark) or THERMOUNT (tradename) or polypropylene fibres.

It is true that the use of halogen-free epoxy resin compositions comprising a phenol novolac epoxy resin, triazine modified phenol novolac resin and phosphor containing flame retardants were known from e.g. the Japanese patent applications JP2000239491, JP200212403, JP2000136292, JP2000129091, JP2000129089, JP200007899, JP200007898, JP-11043536, JP-09207271, JP-08253557. However no suggestion or teaching was given to a person skilled in the art in any of these documents to reach the surprisingly improved properties of the selected compositions by selection of each of the respective ingredients from a great variety of possible compounds.

### EXAMPLES

The following examples and comparative examples are given to further illustrate the present invention, however, without restriction its scope to these embodiments.

### Comparative Example of intermediate phenol resin W.

The product is available from JER (Japan) as YLH 828 and produced accordingly to JP 2001 226464. The properties of this phenol-triazine modified resin are shown in Table 1.

### Example of intermediate cresol resin X

The product is available from JER (Japan) as YLH 969 and produced accordingly to JP 2001 226464. The properties of this cresol-triazine modified resin are shown in Table 1.

### Examples 1-5 and Comparatives 1-4

A resin composition was prepared by mixing an amount of the ingredients as listed in Table 2 at room temperature into methyl ethylketone in order to get a 60 wt% solution. The numbers in Table 2 are the quantities expressed in weight percentage. The following ingredients are used in Example 1-5 and Comparatives 1-4:
EPIKOTE 180 epoxy resin; EPIKOTE 1031 epoxy resin; EXOLIT OP910 (a phosphorous compound according to formula (2), wherein R₂=CH_{3,} ex Clariant);VP3710 powder (a phosphorous compound mixture according to formulae (1a) and (1b),ex Schill and Seilacher); Al(OH)3;
A triazine modified phenol novolac, derived from co-condensation of melamine, phenol and formaldehyde as specified in Comparative Example of component W,;
A triazine modified ortho-cresol novolac, derived from co-condensation of melamine, ortho-cresol and formaldehyde as specified in Comparative Example of component X; and
2-methylimidazole in a 10 wt% solution in methyl proxitol was mixed in about 30 minutes with the obtained solution
2-PZ in a 10 wt% solution in methyl proxitol was mixed in about 30 minutes with the obtained solution

A standard glass cloth (7628 style, 200 g/m², epoxy or amino silane finished) of 20 cm x 20 cm, was impregnated with the resin solution by hand.

The impregnated fabric was cured in a forced air circulated oven at 170 °C to reach the B-stage (prepreg). The laminates were then prepared by placing 8 prepreg layers in a Bucher-KHL 100 press. The temperature of the plates was fixed at 180 °C for 2 hours. The applied force was of 0.04 KN/cm² multiplied by the area of the laminate during heating (7-8 °C/min) to 180 °C and 0.4 KN/cm² multiplied by the area of the laminate the rest of the time (2 hours). The laminates were finally cooled down to room temperature, still under high pressure. The cured laminates were cut with a diamond saw, in order to make samples for the various tests, and conditioned in the oven for 1 hour at 100-105 °C. They were then stored in a dessicator (containing silica gel) before testing.

### Testing

The reactivity of the uncured systems(varnishes) was measured by the Gel Time technique on a hot plate at 170 °C. A low Hot Plate Gel Time (HPGT) corresponds to a high reactivity.

The glass transition temperature (Tg) of the cured products was measured to be in the range of 150 to 180°C using a Differential Scanning Calorimeter (DSC) at a heating rate of 20 °C/minute (second run is taken into account).

The vertical burning test of classifying materials as UL94 was carried out according to the "Standard for Flammability Tests of Plastic Materials in Devices and Appliances" issued by the Underwriters Laboratories Inc.

The Pressure Cooker Test was carried out according to the standard test method IPC-TM-650 2.6.16. A value of 5 corresponds to no measles, no blisters or surface erosion. A value of 1 indicates large blisters, delamination or convolution.

**Table 1**

| | W | X |
|---|---|---|
| Equivalent of hydroxyl group | | |
| (g/equivalent) | 148 | 148 |
| Softening temperature | | |
| (°C) | 128 | 117 |
| Nitrogen content | | |
| (%) *1 | ca 20 | ca 15 |

| | | |
|---|---|---|
| *1 : Element analysis | | |

From the example in Table 2 one can apreciate that the formulations(examples 1-5) based on a combination of cresol-triazine modified phenol resin, such as resin YLH 969, and of a cresol novolac epoxy resin and ofcombination of 2 phophorous compounds lead to cured laminates with high Tg,V-0 and an excellent resistance in the HPCT.

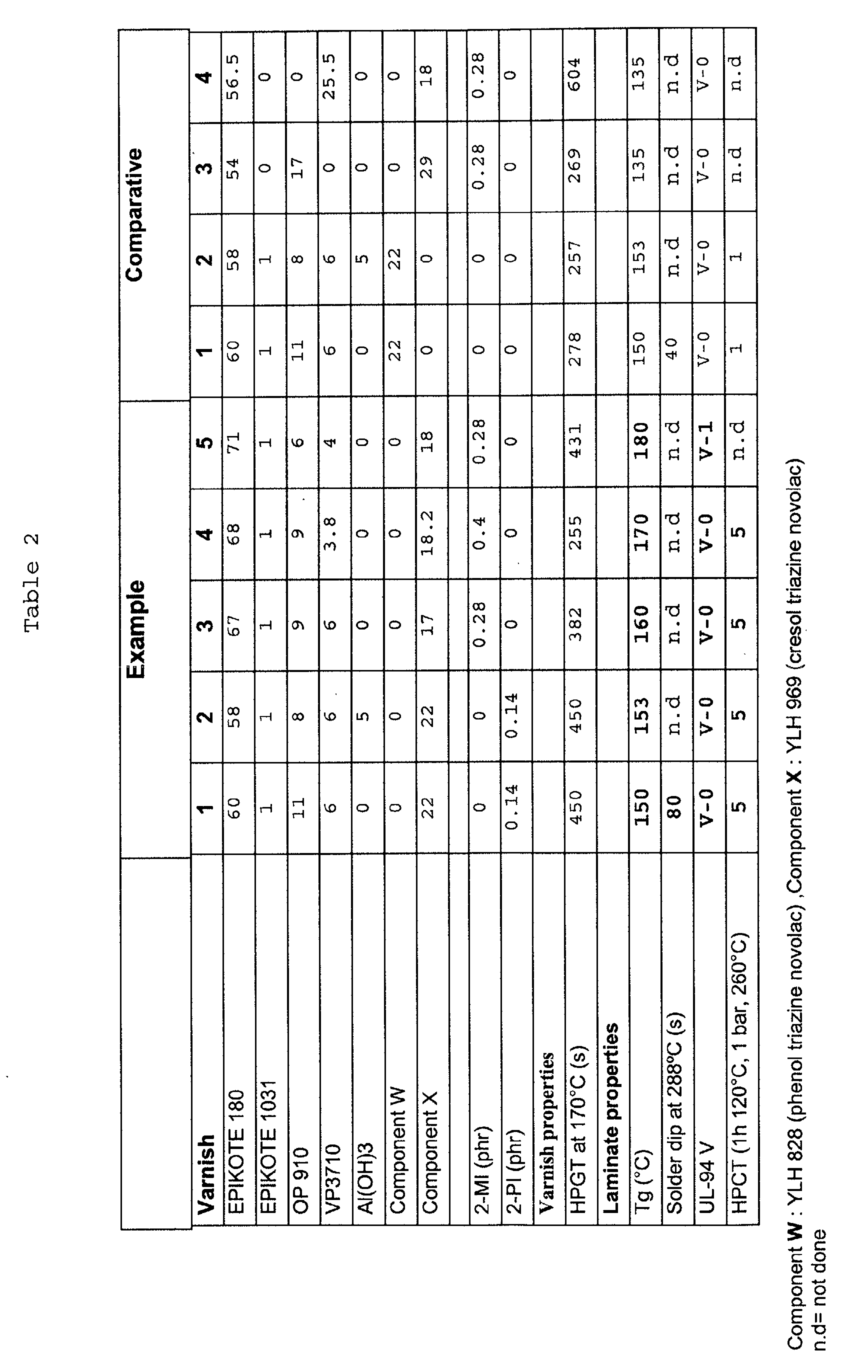

## Claims

1. Curable flame-resistant substantially halogen free epoxy resin compositions, comprising:
(a) one or more bifunctional and/or polyfunctional epoxy resin;
(b) at least one phosphorous-containing compound selected from the group consisting of: 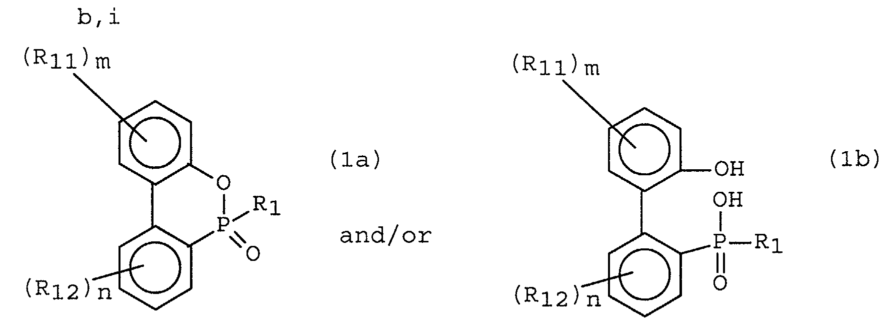 wherein R₁ represents hydrogen or an alkyl group having from 1 to 8 carbon atoms and preferably from 1 to 4 carbon atoms, wherein R₁₁ and R₁₂ are the same or different and both may represent hydrogen or alkyl having from 1 to 3 carbon atoms and wherein m and n are the same or different integers from 0 to 4.
b,ii at least one compound selected from the group selected from 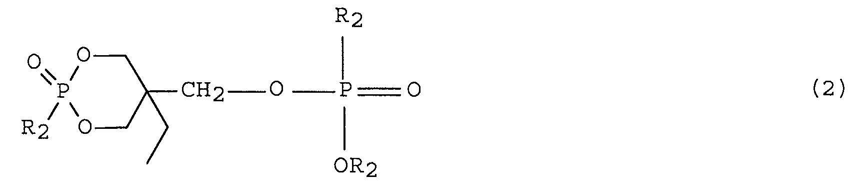 and/or 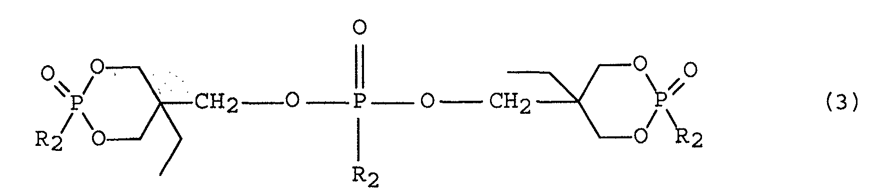 and mixtures thereof,
wherein R₂ represents an alkyl group having from 1 to 4 carbon atoms, and preferably 1 carbon atom, and
(c) a curing agent consisting of oligomers triazine modified cresol novolac comprising at least cresol condensate wherein a cresol compound (X) and a triazine compound (Y) have been condensed via aldehydes (Z),
optionally (d) a curing catalyst and optionally (e) additives.

2. Curable flame-resistant substantially halogen free epoxy resin compositions according to claim 1, **characterized in that** component (c) is a triazine modified cresol novolac, comprising at least cresol condensate wherein a cresol compound (X) and a triazine compound (Y) have been condensed via aldehydes (Z);

3. Curable flame-resistant epoxy resin compositions according to claims 1-2, **characterized in that** they have a phosphorous content of 1.5 to 4.5 wt%, relative to the weight of the complete composition.

4. Curable flame-resistant epoxy resin compositions, according to claims 1-3, **characterized in that** as curing catalyst 2-methyl imidazole and/or 2-phenylimidazole have been included.

5. Curable flame-resistant epoxy resin compositions, according to claims 1-4, **characterized in that** at least one polyfunctional epoxy resin derived from ortho cresol novolak has been included.

6. Curable flame-resistant epoxy resin compositions, according to claims 1-5, **characterized in that** as component (b) phosphorous containing compounds of formulae 1 and 2, wherein R₂=CH₃, have been included.

7. Curable flame-resistant epoxy resin compositions according to claims 1-6 **characterized in that** the mutual weight ratios of components (a), (b), (c), (d), and (e) are in the range of from 50-80 wt%; 5-20 wt%; 15-30 wt%; 0.0- 5 wt%; 0-40 wt%; the sum of the component amounts being 100%.

8. Curable flame resistant epoxy resin compositions according to claim 7, **characterized in that** the mutual weight ratios of components (a), (b), (c), (d) and (e) are more preferably in the range from 55-75 wt%; 10-18 wt%; 15-25 wt%; 0.0- 1 wt%; 0-10 wt%, the sum of the component amounts being 100%.

9. Prepregs derived from curable flame resistant substantially halogen free epoxy resin compositions according to claims 1-8 by impregnation of chopped glass fibres, glass matt or porous non-woven or woven webs of glass fibre or aramide fibres or polypropylene fibres.

10. Laminates derived from prepregs according to claim 9.

11. Printed circuit boards for electronic or electrical equipment derived from prepregs according to claim 10.
